(19) **Europäisches Patentamt**
**European Patent Office**
**Office européen des brevets**

(11) **EP 2 362 199 A1**

(12) **EUROPEAN PATENT APPLICATION**

(43) Date of publication:
**31.08.2011 Bulletin 2011/35**

(51) Int Cl.:
*G01K 7/32* (2006.01)    *H03H 9/02* (2006.01)

(21) Application number: **10166586.7**

(22) Date of filing: **18.06.2010**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(30) Priority: **26.02.2010 US 308836 P**

(60) Divisional application:
**10169307.5**

(71) Applicant: **IMEC**
**3001 Leuven (BE)**

(72) Inventors:
• **Rottenberg, Xavier**
  **1030, Schaarbeek (BE)**
• **Jansen, Roelof**
  **3000, Leuven (BE)**
• **Tilmans, Hendrikus**
  **3630, Maasmechelen (BE)**

(74) Representative: **Sarlet, Steven Renaat Irène et al**
**Gevers**
**Intellectual Property House**
**Holidaystraat 5**
**1831 Diegem (BE)**

(54) **TEMPERATURE MEASUREMENT SYSTEM COMPRISING A RESONANT MEMS DEVICE**

(57) The invention relates to a micromechanical resonator device and a method for measuring a temperature. The device comprising a resonator body, an excitation module associated with the resonator body, a control module and a frequency detection module. The resonator body is adapted to resonate separately in at least a first and a second predetermined resonance state, selected by applying a different bias, the states being of the same eigenmode but having a different resonance frequency, each resonance frequency having a different temperature dependence.

**Fig. 6**

EP 2 362 199 A1

**Description**

**TECHNICAL FIELD**

The invention relates to a device and a method for measurement of temperature using a MEMS resonator and more in particular, to a device and method for measurement of temperature using a frequency difference or frequency ratio of two frequencies generated by an excitation means to excite the resonator body into separately in a first and a second resonance state.

The invention also relates to a micromechanical resonator device having a passive temperature compensated resonance frequency.

**BACKGROUND ART**

MEMS-based thermometer implementations can be found in the prior art. A dual-mode resonator is for example presented in "Temperature measurement and compensation based on two vibration modes of a bulk acoustic mode microresonator", M. Koskenvuori et al., IEEE International Conference on Micro Electro Mechanical Systems - MEMS '08, p.78-81, Tucson AZ, USA, 2007. Different vibration modes of a fixed resonator can depict different temperature dependencies of their resonance frequencies. Using these characteristics, one can assess the temperature of the resonator by building oscillators using two vibration modes and comparing their oscillation frequencies. The main drawbacks of this approach are: a) either the oscillator circuits have to be fitted with complex filters and/or diplexers to separate the two frequencies and generate the oscillations, and/or b) the resonator has to be excited with two different sets of electrodes addressing each of the two modes of interest, and c) two oscillator circuits are required.

Another drawback is mentioned in the paper: the difference in frequency changes of the two modes is rather small and the resonant frequencies are close to each other. Therefore: a) a very accurate frequency measurement is needed to accurately deduce the small relative changes in frequency, b) the beat frequency of the two modes is fairly high reducing the sensitivity when using the beat frequency to measure the temperature and c) any mixing products of the two excited modes will degenerate the reference oscillator noise performance.

A dual resonator as in US patent US 7369004 comprises two separate resonators. These two resonators need to have a different temperature dependency for the same resonance mode. These resonators with slightly different dimensions can be excited with equivalent sets of electrodes. The main drawbacks from this approach are: a) the two resonators have to be thermally strongly coupled for their temperature to be equal, while mechanically weakly coupled for their resonances not to interfere and b) this approach requires roughly double the MEMS area and also requires two oscillator circuits.

**DISCLOSURE OF THE INVENTION**

It is an object of the present invention to provide a micromechanical resonator device for more accurately measuring a temperature.

This object is achieved according to the present invention with the micromechanical resonator device having the characteristics of claim 1.

Thereto the micromechanical resonator according to the present invention comprises - a resonator body; - an excitation means associated with the resonator body and adapted for exciting the resonator body; - a control means connected to the excitation means and adapted for controlling the excitation means to excite the resonator body; wherein - the resonator body is adapted to resonate in a first and a second predetermined resonance state, the first and second resonance states being of the same eigenmode but having different resonance frequencies, the resonance frequencies having a different temperature dependency; - the control means is adapted to supply to the excitation means separately a first bias to excite the resonator body into the first resonance state, and a second bias to excite the resonator body into the second resonance state; whereby the micromechanical device further comprises: - a frequency detection means associated with the resonator body, adapted for detecting a frequency at which the resonator body resonates; - a temperature determination means connected to the frequency detection means and adapted for determining a temperature of the micromechanical resonator device from a first frequency, detected while the resonator body is in the first resonance state, and a second frequency, detected while the resonator body is in the second resonance state.

By applying two different biases to the excitation means, the resonator body can be brought in a first or a second resonance state. The inventor has found that resonance states of the same eigenmode but corresponding to different biases show a different temperature behaviour. This is different from what was already known in the art, namely that resonance frequencies of different eigenmodes of a resonator show different temperature behavior. As the resonance states feature different temperature coefficients of the frequency, the temperature information can be deduced by measuring the frequency change of both states. Only one resonator and a single excitation means are required. This reduces the chip area but also guarantees that the actual resonator temperature is measured.

By using a single resonator structure to measure both frequencies instead of using two resonator structures, a higher temperature measurement accuracy can be achieved because any temperature difference between the two structures is eliminated.

By measuring two frequencies instead of only one, the absolute frequency values are not required, only the relative frequency values, so that an absolute time-base can be omitted.

Preferably the temperature determination means comprises circuitry for determining a frequency difference and/or a frequency ratio using a look-up table and/or a mathematical relationship for determining the operation temperature. By using subtraction and/or division circuitry, the relative deviations of the first and second frequencies can be determined, from which deviations the temperature can be derived using a look-up table and/or a mathematical relationship representative of the temperature dependencies.

In an embodiment the control means is adapted for exciting the resonator body in the first resonance state and the second resonance state alternately. By alternately measuring the first and second resonance frequencies, the temperature can be constantly updated using the two most recent values.

Preferaby the temperature dependency of the resonance frequency of the first resonance state is inverse to the temperature dependence of the resonance frequency of the second resonance state, meaning that one resonance frequency increases with temperature while the other decreases. In this way the average frequency of the resonator stays more stable with temperature as compared to the case where two frequencies would be used having a temperature dependency of the same sign. Alternatively the temperature dependencies can have the same sign but have a measurable different slope.

Preferably the resonator body comprises a material selected from the group of (poly)silicon, diamond, ruby, sapphire, quartz, alumina, nickel and SiGe, as these materials allow fairly standard manufacturing techniques.

Preferably the resonator body comprises a bar resonator suspended above a substrate. A bar resonator has the advantage over a plate resonator that it occupies less space, which is more economical.

Preferably the substrate comprises a material selected from the group consisting of silicon, diamond, ruby, sapphire, glass, quartz, alumina and LCP, as these materials are commonly used substrate materials.

It is also an object of the present invention to provide a method for measuring a temperature of such a micromechanical resonator device. This object is achieved by a method according to claim 10.

It is also an object of the present invention to provide a micromechanical resonator device having a passive temperature compensated resonance frequency.

This object is achieved according to the present invention with the micromechanical resonator device having the characteristics of claim 13.

Thereto the micromechanical resonator device comprises: - a resonator body suspended above and anchored to a substrate and adapted to resonate in a predetermined resonance state at the predetermined resonance frequency; - an excitation element adapted for exciting the resonator body, the excitation element and the resonator body being separated from each other and together forming a transconductive structure; - a control means connected to the excitation element adapted for applying a predetermined bias to the excitation element to excite the resonator body into the predetermined resonance state; wherein - the resonance state is a mechanical vibration mode parallel to the plane of the substrate; - the material of the resonator body and the material of the substrate are selected such that the ratio of the coefficient of thermal expansion of the substrate material and the coefficient of thermal expansion of the resonator body material is larger than 1,0; - the transconductive structure has a transconductance with a predetermined temperature dependency which is defined by a set of parameters, the set of parameters comprising the material of the resonator body, the material of the substrate, the geometry of the resonator device and the predetermined bias and being selected such that at a predetermined temperature, the predetermined temperature dependency of the transconductance compensates the intrinsic temperature dependence of the resonance frequency. The inventor has found that a resonator having a vibration mode parallel to the plane of the substrate can also be used for passive temperature compensation, by using a structure and materials for the resonator body and the substrate satisfying certain conditions, as described in the claim. With transconductive structure is meant a structure between the excitation element and the resonator body where over the bias voltage is applied, and by which the resonance frequency can be tuned, such as e.g. a gap or an interdigitized structure.

An advantage of this structure over the structure described by Tucson AZ is that the slope of the temperature dependency can be tuned or selected by choosing proper biases, allowing to increase the accuracy of the measurement.

In one embodiment the resonator body is a free-standing bar resonator adapted to resonate in a longitudinal vibration mode above and parallel to the plane of the substrate. As most resonators use a flexural vibration mode, the inventor was surprised to see that a longitudinal vibration mode, i.e. the expansion / compression of a bar resonator can be used to generate a stable resonator frequency. Advantageously, a closed form formula can be calculated for this structure.

In an alternative embodiment the micromechanical body is a free-standing bar resonator adapted to resonate in a flexural vibration mode above and parallel to the plane of the substrate. Most resonators, especially plate resonators using a flexural vibration mode, use a vibration mode substantially perpendicular to the substrate. Being able to use also other modes to achieve temperature stabilization allows many more structures to be used, offering more degrees of freedom and other trade-offs that can be made depending on the application.

In another embodiment the micromechanical resonator device comprises an interdigitated structure with a first set of fingers connected to the excitation element and a second set of fingers connected to the resonator body, wherein the set of parameters further comprises an overlap between the first and second set of fingers. Whereas most micromechanical resonator structures use a gap having a stiffness that varies with the applied bias, the inventor found that another principle can be used to obtain the same effect, namely by using an interdigitized structure between the excitation element and the resonator body. A similar role that was played by the gap, is now played by the overlapping distance.

## BRIEF DESCRIPTION OF THE DRAWINGS

Presently preferred embodiments are described below in conjunction with the appended drawing figures, wherein like reference numerals refer to like elements in the various figures, and wherein:

Figures 1A-1F show a bar resonator provided for resonating in longitudinal mode.
Fig 1A shows a cross section of a bar resonator and a gap.
Fig 1B shows the bar resonator of Fig 1A in a cross section perpendicular to the substrate.
Fig 1C shows an embodiment of the bar resonator of Fig 1A.
Fig 1D shows a top view of the bar resonator of Fig 1C.
Fig 1E shows another embodiment of the bar resonator of Fig 1A.
Fig 1F shows a top view of the bar resonator of Fig 1E.
Fig.2 shows a plot of the resonance frequency as a function of the operating temperature, for a silicon bar resonator on a silicon substrate, whereby no bias voltage is applied.
Fig.3 shows a plot of the bias voltage dependency of the resonance frequency.
Fig.4 shows a plot of the temperature dependency of the resonance frequency for different bias voltages.
Figures 5A-5B illustrate the evolution of the transduction gap for an increasing temperature.

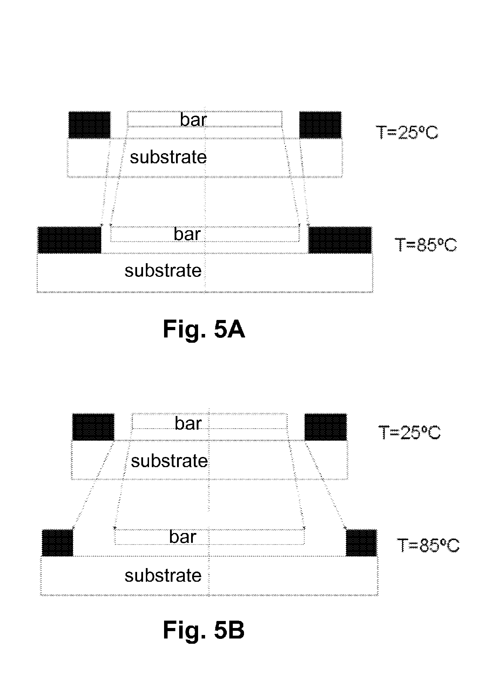

Fig 5A shows the evolution of the transduction gap when the thermal expansion of the bar resonator is smaller than that of the substrate.
Fig 5B shows the evolution of the transduction gap when the thermal expansion of the bar resonator is larger than that of the substrate.

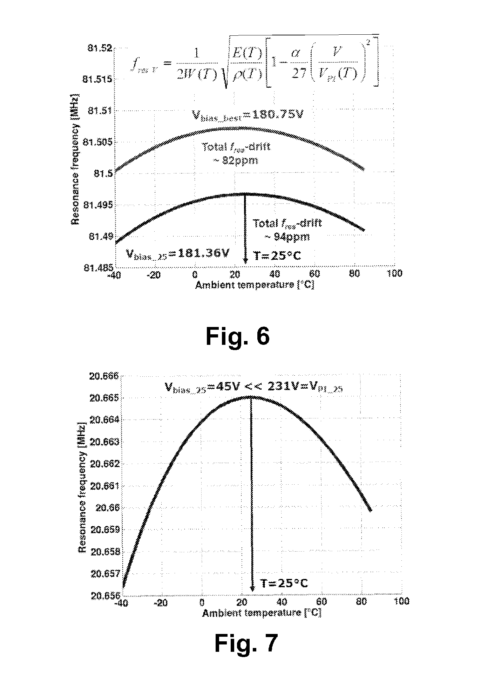

Fig.6 shows a plot of the passive temperature compensation.
Fig.7 shows a plot of the temperature dependency of the frequency with temperature compensation.

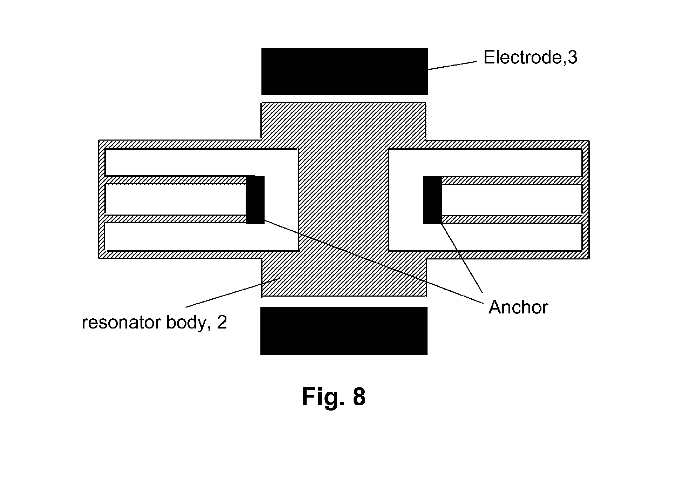

Fig 8 shows another embodiment of a resonator with a gap according to the present invention.

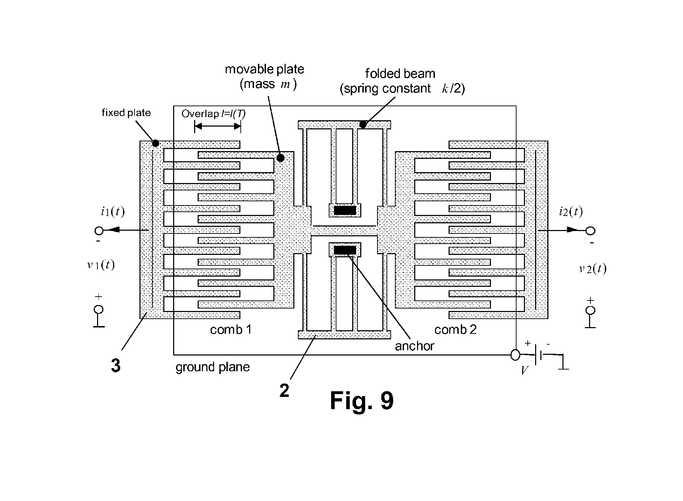

Figures 9 - 12 show embodiments of a resonator structure with an interdigitated structure according to the present invention.

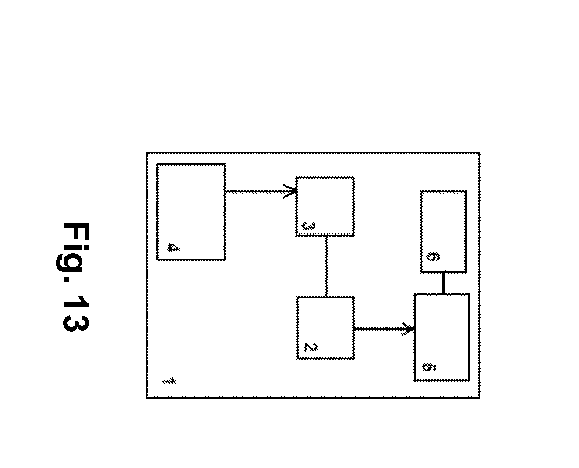

Fig.13 shows a block diagram of a resonator device according to an embodiment of the present invention.

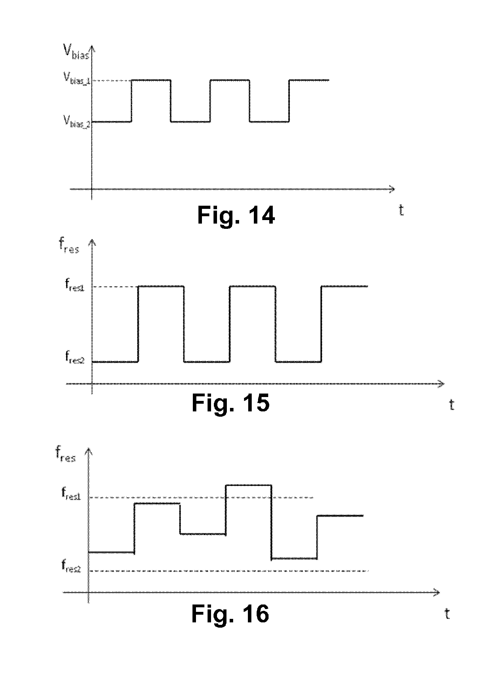

Fig.14 illustrates an alternating bias voltage over time.

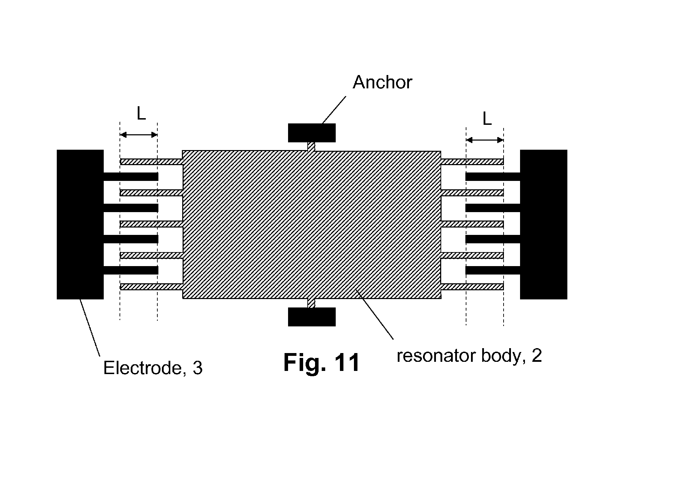

Fig.15 illustrates a first and a second resonating frequency over time at a constant temperature, corresponding to the alternating bias voltages of Fig 11.
Fig.16 illustrates a first and a second resonating frequency over time for a varying temperature, corresponding to the alternating bias voltages of Fig 11.

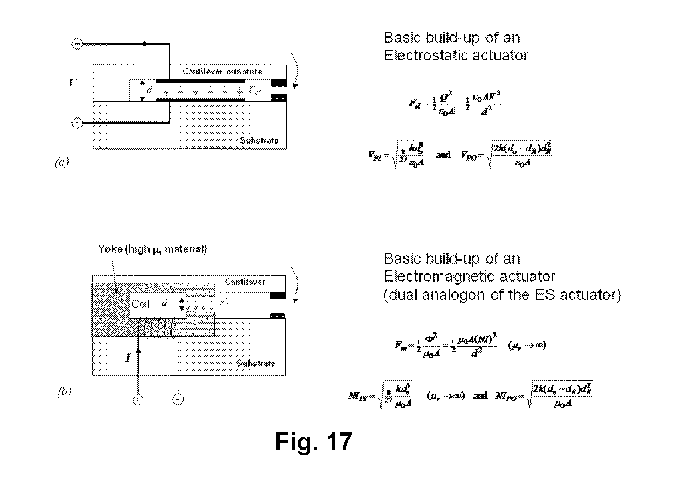

Fig.17 illustrates build ups of different actuations mechanisms.

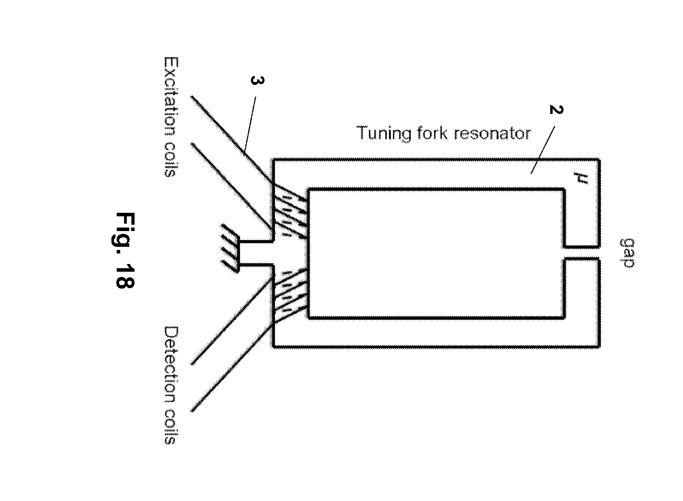

Fig.18 shows a resonator device according to an embodiment.

## DETAILED DESCRIPTION OF CERTAIN ILLUSTRATIVE EMBODIMENTS

The present invention will be described with respect to particular embodiments and with reference to certain drawings but the invention is not limited thereto. The drawings described are only schematic and are non-limiting. In the drawings, the size of some of the elements may be exaggerated and not drawn on scale for illustrative purposes.

Furthermore, the terms first, second, third and the like in the description are used for distinguishing between similar elements and not necessarily for describing a sequential or chronological order. The terms are interchangeable under appropriate circumstances and the embodiments of the invention can operate in other sequences than described or illustrated herein.

Moreover, the terms top, bottom, over, under and the like in the description are used for descriptive purposes and not necessarily for describing relative positions. The terms so used are interchangeable under appropriate circumstances and the embodiments of the invention described herein can operate in other orientations than described or illustrated herein.

The term "comprising" should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting of only components A and B. It means that with respect to the present description, the only relevant components of the device are A and B.

Micro-Electro-Mechanical (MEM)-resonators are recognized key components for future sensing, wireless and communications applications [1], [2]. Si-based resonators have gained special interest since they offer the perspective to replace bulky quartz resonators on-chip, maintaining high Q-factor (such as e.g. 1000 or more) and reaching high frequencies (such as e.g. 100 MHz or more). In various applications, e.g., time-reference, the temperature (T-) stability is of paramount importance. ET, the T-coefficient of Young's modulus (E), typically dominates the intrinsic T-dependence of the resonance frequency, $f_{res}$. For Si-based MEM resonators this T-dependence is much larger than for quartz crystal resonators, and too large to allow the passive implementation of these resonators in wide T-ranges such as e.g. -40°C to +85°C. To circumvent this problem, two main approaches have been proposed in literature: 1) Coating the resonator with negative ET materials, such as e.g. SiOx, lowers the effective ET, thus enhancing the T-stability [2]. This passive approach increases the processing complexity and cost, but is often not effective to fully compensate the T-drift and significantly degrades other resonator characteristics, e.g., the quality factor (Q-factor). 2) Implementing an active control loop, e.g. composed of a thermometer and a heater around the resonator allows limiting its T-excursion, thus its T-drift, at the expense of increased design/process complexity and power consumption.

Several solutions addressing the issue of temperature compensation are known. US 6987432, discloses active and passive solutions. An active solution comprises determining the actual operating frequency for a beam resonator in relation to a desired resonance frequency, and thereafter applying a compensating stiffness to the resonator to maintain the desired resonance frequency. Passive solutions for frequency stabilization with temperature of a MEMS resonator include for example a method of fabricating a micromechanical resonator. US 7427905 discloses a temperature controlled MEMS resonator and a method for controlling resonator frequency by providing an electrical current to the beam structure and thereby heating the beam structure.

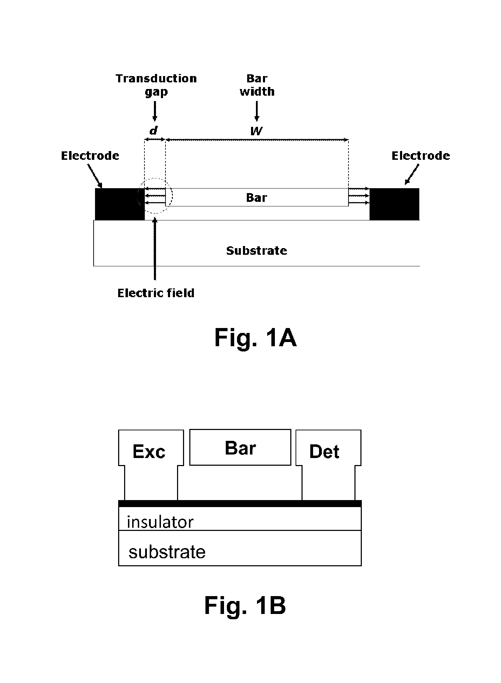

The majority of RF-MEMS devices rely on electrostatic actuation, therefore one embodiment of the present invention will be exemplified by means of such MEMS device but the invention is not limited hereto. Figure 1A-1F presents a MEM bar resonator, i.e. a free-standing parallelepipedic bar 2, typically made of silicon. The resonator is anchored to the substrate through two tethers (also called anchors) placed on opposite sides of the bar 2, and substantially in the middle thereof. Its two remaining opposite sides are further neighbored by two fixed electrodes, namely an excitation electrode and a detection electrode that respectively provide for electrostatic excitation and detection through two thin transconduction gaps, d. According to the invention, the bar is operated in a longitudinal mode of vibration, which can be done by exciting it using proper frequencies by methods known in the art. In this so-called longitudinal extensional mode both transduction gaps (on either side of the bar) shrink/expand in phase. The fundamental resonant frequency (also called natural frequency) $f_{res}$ for a bar resonator resonating in longitudinal mode is in first approximation given by (1) where $W$ and $p$ are the width and mass density of the bar.

$$f_{res} \cong \frac{1}{2W} \sqrt{\frac{E}{\rho}} \tag{1}$$

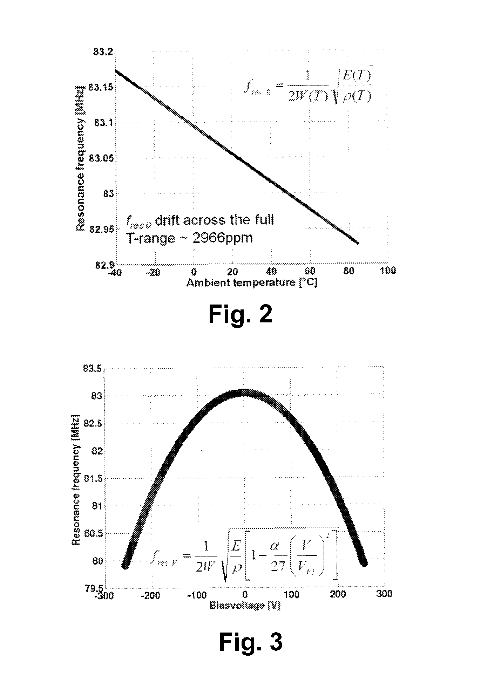

Expressing the T-dependencies in (1), the intrinsic T-drift of the natural frequency is shown in Figure 2, indicating W(T), E(T) and p(T). The temperature dependency of the natural frequency is shown of a bar resonator produced in silicon at 25°C, $W_{25}$ = 50 $\mu$m, $E_{si-25}$ = 160 GPa, ps;_25 = 2320 kg/m$^3$, CTE$_{si}$ = 2,6 ppm/°C and ET$_{Si}$ = -50 ppm/°C. Note that ETsi dominates CTE$_{si}$ (CTE=coefficient of thermal expansion), which relation is also true for other materials typically used. The T-drift is almost linear with slope close-to ET$_{Si}$/2.

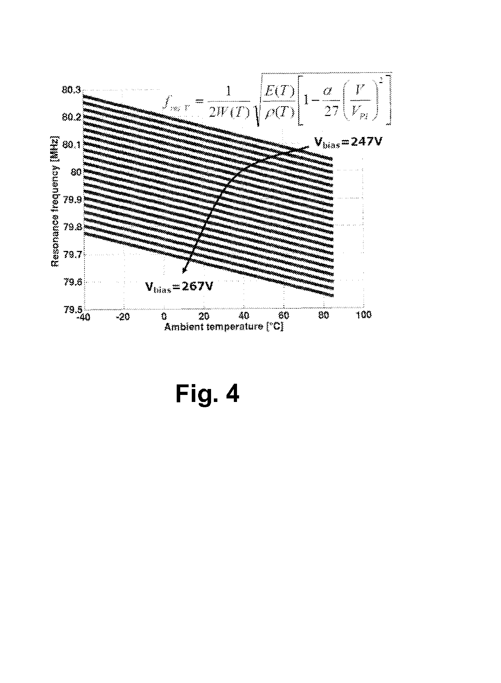

MEM resonators require DC-biasing for their linear operation. Note that V used in formula (2) equals the bias voltage Vbias. This DC-offset introduces a parasitic electrostatic spring softening that results in a shift of $f_{res}$ expressed by (2) for V « V$p_l$, (where V$_{PI}$ is the modal pull-in voltage, i.e. the static voltage that leads to a mode-collapse). Figure 3 and Figure 4 demonstrate this known effect [3], considering V$_{PI}$ fixed. Figure 3 plots the V-dependency of the resonance frequency of the bar resonator with fixed transduction gap d = 100 nm and for a fixed temperature. Figure 4 plots the T-dependency of the resonance frequency of the DC-biased bar resonator neglecting the T-dependency of V$_{PI}$, according

formula (2) which is valid for $V \ll Vp_l$

$$f_{res} = \frac{1}{2W} \sqrt{\frac{E}{\rho} \left[ 1 - \frac{\alpha}{27} \left( \frac{V}{V_{PI}} \right)^2 \right]} \qquad (2)$$

whereby $\alpha$ is a constant depending on the resonator structure and resonance mode used. For the bar resonator described above resonating in longitudinal (extensional) mode. $\alpha$ is estimated to be a value from 5,0 to 9,5, probably approximately a value from 6,5 to 8,0.

In practice however, $Vp_l$ does depend on T through the material properties ($Vp_l = Vp_l$ (T)) and geometry of the bar but also through the transduction gap d which is an increasing or decreasing function of T depending on $CTE^*_{sub}$ defined as the ratio of substrate-to-bar CTE's as shown in Figure 5A and Fig 5B, assuming d«W. Figures 5A and 5B show the evolution of the transduction gap d for an increasing temperature T in the case of substrate expansion smaller (Fig 5A) or larger (Fig 5B) than the resonator bar expansion, i.e. $CTE^*_{sub} < 1$ or $CTE^*_{sub} > 1$ respectively. The inventor found that, while the temperature dependence of the resonance frequency as expressed by formula (1) was primarily determined by $ET_{bar}$, a fixed material characteristic, the temperature dependence of the resonance frequency $f_{res},v$ as expressed by formula (2) can be tuned by design or by selecting the working point, i.e. the DC bias voltage (V) and can be chosen positive or negative through an appropriate combination of resonator and substrate materials. This allows the passive compensation of the temperature-dependence of bar-resonators. Expressing T in $Vp_l$, and imposing a zero-slope of $f_{res}(T)$ in $T=To$, where To is a selected temperature, delivers the condition (3) linking normalized material properties, bar dimensions and working point (V) at $T=T_0$ such that fres is locally independent of T. This condition can be fulfilled by typical materials provided $CTE^*_{Sub}$ is >1, such as e.g. a silicon bar on a sapphire substrate, having a $CTE^*_{sub}$ of approximately 1,6 (as CTE=4,3 ppm/°C for sapphire). Note that in fact the absolute value of $ET^*bar$ should be used on the left hand side of formula (3), alternatively, a minus-sign can be added before $ET^*bar$.

$$ET^*_{bar} = 1 + \frac{\alpha}{27} \left( \frac{V}{V_{PI\_0}} \right)^2 \left\{ 3 \left[ CTE^*_{sub} + \frac{W_0}{2d_0} \left( CTE^*_{sub} - 1 \right) \right] - 2 \right\} \qquad (3)$$

$$\text{with:} \qquad ET^*_{bar} = \frac{ET_{bar}}{CTE_{bar}} \qquad (4)$$

$$CTE^*_{sub} = \frac{CTE_{sub}}{CTE_{bar}} \qquad (5)$$

$$V_{pi\_0} = \sqrt{\frac{16}{27} \frac{E_0 d_0^3}{\varepsilon_0 W_0}} \qquad (6)$$

For selected materials, the formula (3) gives a relation between $V_{bias}$, Wo and do, thus between the geometry of the resonator and the bias voltage. This implies that the zero-slope at $T=T_0$ only applies for a single $V_{bias}$.

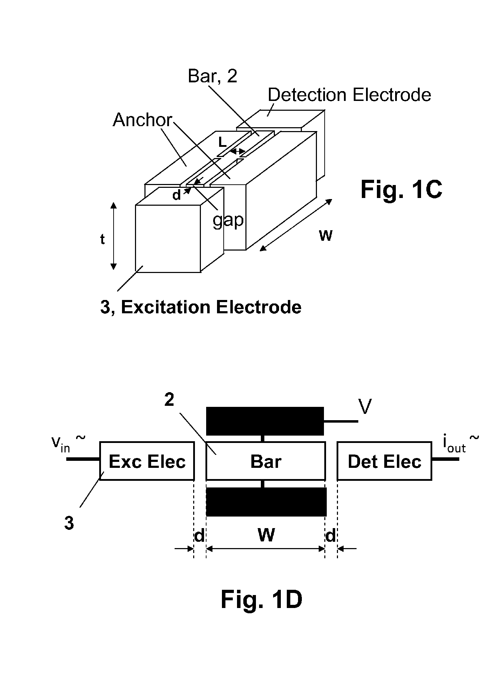

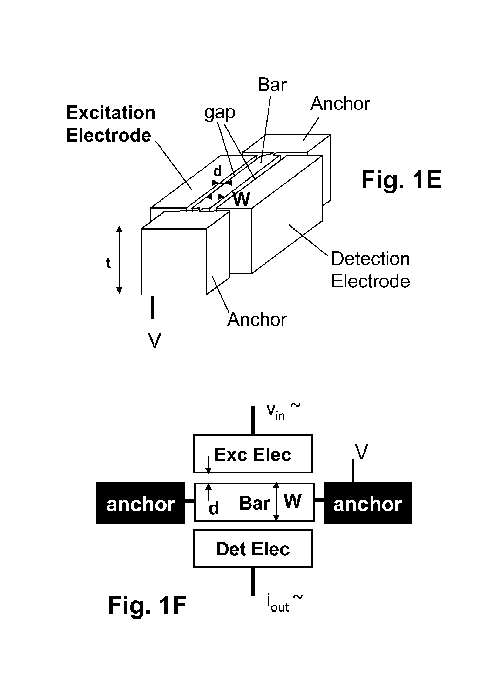

Figure 6 shows the T-compensation of the silicon bar resonator from Figure 1 having the same intrinsic characteristics as shown in Figure 2 and Figure 3 processed on a sapphire substrate, when applying a $V_{bias}$. Different bias points compensate the T-drift at different temperatures. In best condition, the drift lowers from the intrinsic 2966ppm to 82ppm over the temperature range from -40°C to +85°C. However, a large bias voltage (approximately 181V) is needed. In order to lower the DC bias voltage, or more precisely the ratio of the bias voltage and the pull-in voltage $Vp_l$, condition (3) defines two options: Either the material properties of the substrate-resonator combination can be modified, or the resonator and transduction gap can be redesigned to increase the ratio Wo/do, or a combination of both. As an example, consider the device simulated in Figure 7 (at room temperature). With **W=200** $\mu$m and keeping the other parameters the same as above, a $V_{bias}$ of approximately 45V suffices to compensate the T-drift at the resonance frequency. Note that by changing the dimensions of the bar resonator, also the value of the resonance frequency has changed from approximately 81,5 MHz to approximately 20.6 MHz, but in typical applications this is not a problem, because it is relatively easy to derive another frequency (e.g. using a PLL) starting from a stable (i.e. temperature independent) frequency. The bias voltage can be used to account for process inaccuracies and to select the temperature of ideal compensation, i.e. to tune the resonator frequency.

With the above mentioned results, a passive compensation of the T-drift of electrostatically-driven MEM-resonators can be enabled. The key of this implementation is the T-driven modulation of the transduction gap that, controlled by design, can fully balance the T-drift due to the intrinsic material properties of the resonator, notably the choice of the bar and substrate materials and the geometry of the bar resonator, in particular the W and d. The further selection of the optimum bias working point V allows compensating for potential processing inaccuracies. In other words, by choosing appropriate materials and appropriate values of the DC-bias voltage and gap the resonance frequency increase with temperature can be tailored to exactly cancel the intrinsic resonance frequency decrease with temperature.

Analogous, a passive compensation approach can be enabled for MEMS resonating devices using electromagnetic transduction (as illustrated in Figure 17). Likewise, the T-driven modulation of the transduction gap that, controlled by design, can fully balance the T-drift due to the intrinsic material properties of the resonator. The further selection of the optimum bias working point allows compensating for potential processing inaccuracies. In other words, by choosing appropriate values of the bias, in this case ampere-turns NI (a magnetomotive force mmf instead of an electromotive force emf), and gap the resonance frequency increase with Temperature can be tailored to exactly cancel the intrinsic resonance frequency decrease with temperature.

A method for designing a micromechanical resonator device is presented. The method comprises the steps of: determining a first temperature dependency of the resonant frequency and compensating the device for the temperature dependency of the resonant frequency in a predefined working point within a predetermined temperature range. The compensation step comprises the steps of: determining a second temperature dependency of the excitation signal generated by the excitation means 3 (i.e. a $V_{bias}$ or $NI_{bias}$) upon excitation of the resonator body 2; and designing the gap, such that the second temperature dependency cancels out the first temperature dependency in the predetermined temperature range in a selected working point, e.g. applied bias voltage for electrostatic transduction or applied bias current for electromagnetic transduction.

Figure 8 shows another resonator structure with a bar resonator body, separated from two electrodes by a gap, and suspended above a substrate using suspension beams which are connected to anchors. This structure can also be excited in a mechanical vibrating mode parallel to the substrate. Similar as explained above, by choosing proper dimensions of the resonator structure, materials, gap and bias voltage, this resonator structure can be designed such that it has a resonance frequency with a zero slope (read: temperature independent) at a selected working point, defined by To and Vo.

Figures 9 shows an interdigitized structure acting as a transductance structure, connected to a flexural beam structure, provided to resonate in a mode parallel to the plane of the substrate at a predefined resonance frequency. When applying different bias voltages to the resonator body 2, the resonance frequency will slightly vary, but more important for the invention, they will have a different temperature dependence, i.e. a different slope. The role of the gap distance d in the bar oscillator described above, is now taken by the overlapping distance L, where L is a function of the temperature L(T), due to thermal expansion of the resonator body 2 and the substrate. According to the invention, by choosing the resonator material and substrate materials and the dimensions of the structure and the bias voltage and the overlapping distance L in a particular way, the structure can be used as a passive temperature compensated resonator. The number of fingers (or plates) need not be the same as shown in Fig. 8, but can be chosen by the person skilled in the art.

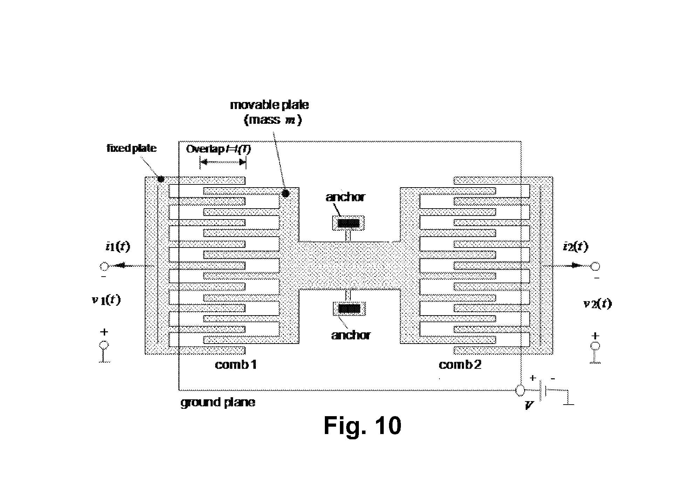

Figures 10 and 11 show a variant of the structure of Fig 9, with a bar resonator resonating in a longitudinal extension/compression mode as explained above, but instead of a gap d (as in Figures 1A-1 F), now the transconductance structure is an interdigitized structure having an overlapping distance L, and the same reasoning as for Figure 9 is also applicable.

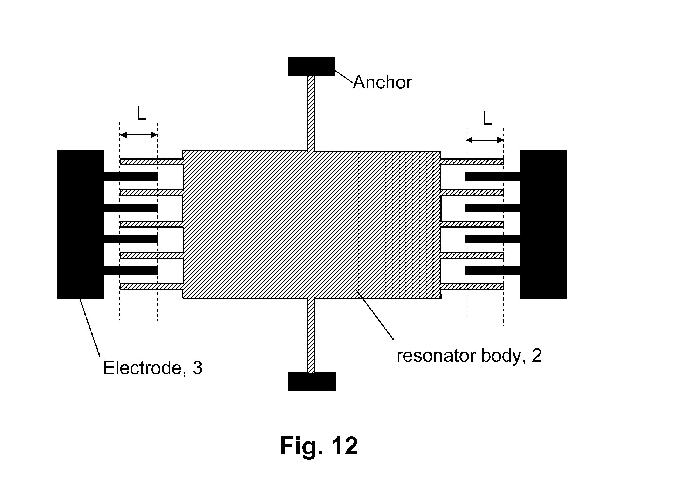

Figure 12 shows yet another variant, whereby the bar resonator is suspended via long beams to the substrate. This structure allows the longitudinal vibration mode described for Figure 11, but also allows another mode, a flexural mode in which the resonator body moves from left to right instead of expanding/compressing.

Another inventive aspect is directed to a temperature measurement system. The system comprises a micromechanical resonator device, comprising a resonator body 2, an excitation means 3 associated with the resonator body 2, a control means 4 and a frequency detection means 5. The resonator body is adapted to resonate in at least a first and a second predetermined resonance state, the first and second predetermined resonance states being of the same eigenmode but having a different resonant frequency, whereby the frequency varies differently with varying operating temperature T. The excitation means 3 (for example an electrode or a coil) is associated with the resonator body 2 and is arranged for exciting the resonator body 2 in a particular resonance mode. The control means 4 is connected to the excitation means 3 and is provided for controlling the excitation means 3 to excite the resonator body 2 into the first and second resonance states. The frequency detection means 5, associated with the resonator body 2, is arranged for detecting a frequency at which the resonator body 2 resonates.

For the thermometer, the resonator structure can be a temperature compensated structure as described above, but this is not required. Using a temperature-compensated structure and bias voltages corresponding to an inverse temperature dependence might be advantageous in applications where the average frequency should remain constant, but other structures and biases will also work for measuring a temperature, if the resonance frequency need not be constant.

The states feature different temperature coefficients of the resonance frequency and therefore by measuring the frequency change of both states (corresponding to both biases) the temperature information can be deduced. Only one resonator 2 and a single excitation means 3 are required. This reduces the chip area cost but also guarantees that the actual resonator temperature T is measured.

In an embodiment, the control means 4 is adapted to supply to the excitation means 3 a first bias to excite the resonator body 2 into the first resonance state, and a second bias to excite the resonator body 2 into the second resonance state. In an embodiment the first bias comprises a first DC voltage component and the second bias comprises a second DC voltage component. In another embodiment, the first bias comprises a first current component and the second bias comprises a second current component.

In an embodiment, the control means 4 is adapted to supply the first and second biases alternately.

In an embodiment, the temperature dependence of the resonant frequency of the first resonance state is opposite/inverse to the temperature dependence of the resonant frequency of the second resonance state, i.e. they have opposite signs.

In an embodiment, the micromechanical resonator device further comprises a temperature determination means connected to the frequency detection means and provided for determining a temperature from a first frequency, detected while the resonator body 2 is in the first resonant state, and a second frequency, detected while the resonator body 2 is in the second resonant state. A shift in the first and/or second frequency or a ratio between the first and second frequency $f_{res}1$, $f_{res2}$ is monitored by the temperature determination means 6 (e.g. a control circuit) thereby providing an output signal Tout related to the operating temperature T. The temperature determination means 6 may include processor circuitry arranged for determining the operation temperature T using a look-up table and/or a mathematical relationship.

In an embodiment the resonator body may be fabricated in (poly)silicon, diamond, ruby, sapphire, quartz, alumina, nickel, SIGe or any other material known to the person skilled in the art.

In an embodiment the micromechanical resonator device is a bar resonator, a plate resonator, a flexural beam resonator, etc. that are electrostatically or electromagnetically excited.

In an embodiment the device may include a substrate and supports for supporting the resonator 2 and the electrode 3 above the substrate. The substrate may be a semiconductor substrate such as a silicon substrate but any other material known by the person skilled in the art may be used e.g. diamond, rubi, sapphire, glass, quartz, alumina, LCP.

In another aspect of the disclosure, a method for designing a micromechanical resonator device 1 is presented. The resonator device 1 comprises a resonator body 2, adapted to resonate in at least one resonant state having a resonance frequency that drifts with temperature, and an excitation means 3 comprising an excitation element (i.e. electrode or coil) placed at a gap from the resonator body 2. The method comprises the steps of: determining a first temperature dependency of the resonant frequency and compensating the device for the temperature dependency of the resonant frequency in a predetermined temperature range. Wherein the compensation step comprises the steps of: determining a second temperature dependency of the excitation signal generated by the excitation means (i.e. a pull-in voltage for electrostatic transduction, a current for electromagnetic transduction) over the gap upon excitation of the resonator body 2 in the resonant state; and designing the gap, such that the second temperature dependency cancels out the first temperature dependency in the predetermined temperature range in a selected working point, e.g. applied voltage for electrostatic transduction or current for electromagnetic transduction.

The device may further comprise a drive electrode structure formed at a position to allow electrostatic excitation of the resonator body 2, and the resonator body 2 and the drive electrode structure 3 may define a gap there between.

The device may further include a magnetic circuit (like a ferromagnetic yoke) and a driving coil formed at a position to allow electromagnetic excitation of the resonator body 2, and the resonator body 2 and the magnetic circuit may define a gap in the latter.

To make a thermometer out of a MEMS resonator, one needs to be able and produce two resonance states with different temperature dependencies, on-chip, in media at the same precise temperature one has to measure. As described above, such states are achieved by using a bar resonator structure resonating in a single eigenmode, e.g. an extensional longitudinal mode, but using two different bias voltages, but the invention is not limited thereto. Other vibration modes parallel to the substrate can also be used, e.g. the bar resonator of Fig 1, but excited in a flexural vibration mode, or using structures (such as shown in Figs 9-12) having an interdigitized structure, where the gap distance d is not determining the frequency but the overlapping distance L. The temperature-driven modulation of the transduction gap in a fixed device can be used to excite a fixed resonance mode (e.g. longitudinal vibration) at (slightly) different frequencies and with different temperature dependencies. A single resonator 2 can be used at two different biases (voltage or current), thereby delivering two different resonance states with a different temperature dependency or in other words, there is a contrast in the temperature dependency of the two resonance frequencies. By tracking the frequency difference or frequency ratio between the two resonance states corresponding to the two biases, one can measure the temperature T with one and only one set-up.

The temperature measurement system is illustrated in Figure 13. The system 1 comprises a micromechanical resonator device comprising a resonator body 2, an excitation means 3 associated with the resonator body 2, a control means 4 and a frequency detection means 5. The resonator body is adapted to resonate in different resonance states of the same mode but having at a different frequency. The temperature dependency of resonance frequency of the two states is different. The control means 4 provides different biases to the excitation means 3 associated to the resonator body. The frequency detection means, 5 associated with the resonator body 2 detects the frequency at which the resonator body resonates.

Preferably, the control means 4 supplies a first and a second bias alternating. This has the advantage that the temperature T is measured at a single location, which is not the case when using two separate resonators. This allows to measure the temperature T with a higher accuracy. Figure 14 shows an example of the alternating bias voltages ($V_{bias-1}$ and $V_{bias\_2}$) over time. When using a clock signal (e.g. an external clock signal) and counters for measuring the frequencies, a clock signal with a 50% duty cycle is preferred, but this is not absolutely required. Accordingly, Figure 15 shows a plot of the resonance frequency ($f_{res1}$ and $f_{res2}$) at which the resonator body 2 resonates for the different applied excitation signals.

The temperature measurement system 1 further comprises a temperature determination means 6 connected to the frequency detection means 5. The temperature determination means 6 is provided for determining a temperature from a first frequency $f_{res1}$, detected while the resonator body 2 is in the first resonant state, and a second frequency $f_{res2}$, detected while the resonator body 2 is in the second resonant state. A shift in the first and/or second frequency due to a varying temperature is monitored by the temperature determination means 6 (e.g. a control circuit) thereby providing an output signal Tout related to the operating temperature. When using two fixed bias voltages, the resonator body 2 will resonate at a different frequency ($f'_{res1}$ and $f'_{res2}$) when the temperature varies. This is illustrated in Figure 16.

The MEM resonator device 1 may be any resonator device known to the person skilled in the art; a bar resonator, a plate resonator, a flexural beam resonator, etc. that are electrostatically or electromagnetically excited. Different actuation mechanisms are introduced in [4] and more in particular electromagnetic actuation in [5]. Both actuation mechanisms are illustrated in Figure 17.

Figure 18 illustrates a resonator device 1 having an electromagnetic actuation means. For this embodiment, the resonator body 2 comprises a tuning fork. The excitation means 3 associated with the resonator body 2 comprises excitation coils. The frequency detection means 5 comprises detection coils.

The device 1 may further comprise a drive electrode structure formed at a position to allow electrostatic excitation of the resonator body 2, and the resonator body and the drive electrode structure may define a gap there between.

The device 1 may further include a magnetic circuit (like a ferromagnetic yoke) and a driving coil formed at a position to allow electromagnetic excitation of the resonator body 2, and the resonator body and the magnetic circuit may define a gap in the latter.

The temperature measurement principle is described above for a bar resonator 2 resonating at the first harmonic, but also works at higher harmonics.

Note that the above mentioned developments, presented in the case of electrostatically transduced resonators, can be directly transposed to the magnetic transduction of MEM resonators. For this, the quantities V (voltage), q (charge) and (permittivity) have to be substituted with $n^*I$ (total winded current), f (magnetic flux) and μ (permeability) respectively.

The foregoing description details certain embodiments of the invention. It will be appreciated, however, that no matter how detailed the foregoing appears in text, the invention may be practiced in many ways. It should be noted that the use of particular terminology when describing certain features or aspects of the invention should not be taken to imply that the terminology is being re-defined herein to be restricted to including any specific characteristics of the features or aspects of the invention with which that terminology is associated.

While the above detailed description has shown, described, and pointed out novel features of the invention as applied to various embodiments, it will be understood that various omissions, substitutions, and changes in the form and details of the device or process illustrated may be made by those skilled in the technology without departing from the spirit of the invention.

**REFERENCES**

[1] S. Stoffels, S. Severi, R. Vanhoof, R. Mertens, R. Puers, A. Witvrouw and H.A.C. Tilmans, "Light sensitive SiGe MEM resonator for detection and frequency tuning applications", proc. MEMS 2010, Hong Kong, 24-28 January, 2010, pp. 691-694.

[2] G. Bahl, R. Melamud, B. Kim, S. Chandorkar, J. Salvia, M. A. Hopcroft, R. G. Hennessy, S. Yoneoka, C. M. Jha, G. Yama, D. Elata, R. N. Candler, R. T. Howe, and T. W. Kenny, "Observations of fixed and mobile charge in composite MEMS resonators," Proc. IEEE Solid-State Sensors, Actuators and Microsystems Workshop, Hilton Head Island, South Carolina, USA, 1-5 June 2008, pp. 102-105.

[3] H. A. C. Tilmans, 1993 "Micromechanical sensors using encapsulated built-in resonant strain gauges", PhD Dissertation Faculty of Electrical Engineering, University of Twente.

[4] H.J. De Los Santos et al., "RF MEMS for Ubiquitous Wireless Connectivity: Part 1 - Fabrication", IEEE Microwave Magazine, p. 36-49, December 2004.

[5] H.A.C. Tilmans, "Equivalent circuit representation of electromechanical transducers: I. Lumped-parameter systems", J. Micromech. Microeng. 6 (1996) 157-176.

**Claims**

1. A micromechanical resonator device (1) for measuring a temperature, comprising:

   - a resonator body (2);
   - an excitation means (3) associated with the resonator body (2) and adapted for exciting the resonator body (2);
   - a control means (4) connected to the excitation means (3) and adapted for controlling the excitation means (3) to excite the resonator body (2);
   **characterised in that**:
   - the resonator body (2) is adapted to resonate in a first and a second predetermined resonance state, the first and second resonance states being of the same eigenmode but having different resonance frequencies, the resonance frequencies having a different temperature dependency;
   - the control means (4) is adapted to supply to the excitation means (3) separately a first bias to excite the resonator body (2) into the first resonance state, and a second bias to excite the resonator body (2) into the second resonance state;
   whereby the micromechanical device (1) further comprises:
   - a frequency detection means (5) associated with the resonator body (2), adapted for detecting a frequency at which the resonator body (2) resonates;
   - a temperature determination means (6) connected to the frequency detection means (5) and adapted for determining a temperature of the micromechanical resonator device (1) from a first frequency, detected while the resonator body (2) is in the first resonance state, and a second frequency, detected while the resonator body (2) is in the second resonance state.

2. The micromechanical resonator device (1) according to claim 1, wherein the temperature determination means (6) comprises circuitry for determining a frequency difference and/or a frequency ratio using a look-up table and/or a mathematical relationship for determining the operation temperature.

3. The micromechanical resonator device (1) according to claim 1 or 2, wherein the control means (4) is adapted for exciting the resonator body (2) in the first resonance state and the second resonance state alternately.

4. The micromechanical resonator device (1) according to any one of the previous claims, wherein the temperature dependency of the resonance frequency of the first resonance state is inverse to the temperature dependence of the resonance frequency of the second resonance state.

5. The micromechanical resonator device (1) according to any one of the previous claims, wherein the resonator body (2) comprises a material selected from the group of (poly)silicon, diamond, ruby, sapphire, quartz, alumina, nickel and SiGe.

6. The micromechanical resonator device (1) according to any one of the previous claims, wherein the resonator body (2) comprises a bar resonator suspended above a substrate.

7. The micromechanical resonator device (1) according to claim 6, wherein the substrate comprises a material selected from the group consisting of silicon, diamond, ruby, sapphire, glass, quartz, alumina and LCP.

8. The micromechanical resonator device (1) according to any one of the claims 1-7, wherein the first bias comprises a first DC voltage and the second bias comprises a second DC voltage.

9. The micromechanical resonator device (1) according to any one of the claims 1-7, wherein the first bias comprises a first DC current and the second bias comprises a second DC current.

10. A method for determining a temperature of the micromechanical resonator device (1) according to any one of the previous claims, comprising the steps of:

   a) applying the first bias to excite the resonator body (2) in the first resonance state, and measuring the first frequency of the first resonance state;
   b) applying the second bias to excite the resonator body (2) in the second resonance state, and measuring the second frequency of the second resonance state;
   c) determining the temperature using the measured first and second frequency.

11. Method according to claim 10, wherein the determination of the temperature using the measured first and second frequency comprises determining a frequency difference and/or a frequency ratio, and using a look-up table and/or a mathematical relationship.

12. The method according to claim 10 or 11, wherein the first bias and the second bias are applied alternately.

13. A micromechanical resonator device (1) having a predetermined resonance frequency ($f_{res}$), comprising

   - a resonator body (2) suspended above and anchored to a substrate and adapted to resonate in a predetermined resonance state at the predetermined resonance frequency ($f_{res}$);
   - an excitation element (3) adapted for exciting the resonator body (2), the excitation element (3) and the resonator body (2) being separated from each other and together forming a transconductive structure;
   - a control means (4) connected to the excitation element (3) adapted for applying a predetermined bias (V, NI) to the excitation element (3) to excite the resonator body (2) into the predetermined resonance state;
   **characterised in that**:

   - the resonance state is a mechanical vibration mode parallel to the plane of the substrate;
   - the material of the resonator body (2) and the material of the substrate are selected such that the ratio of the coefficient of thermal expansion of the substrate material ($CTE_{sub}$) and the coefficient of thermal expansion of the resonator body material ($CTE_{bar}$) is larger than 1,0;
   - the transconductive structure has a transconductance with a predetermined temperature dependency which is defined by a set of parameters, the set of parameters comprising the material of the resonator body (2), the material of the substrate, the geometry of the resonator device ($W_o$, do) and the predetermined bias (V, NI) and being selected such that at a predetermined temperature (To), the predetermined temperature dependency of the transconductance compensates the intrinsic temperature dependence of the resonance frequency ($f_{res}$).

14. The micromechanical resonator device (1) according to claim 13, wherein the resonator body (2) is a free-standing bar resonator (2) adapted to resonate in a longitudinal vibration mode above and parallel to the plane of the substrate substantially at the predetermined resonance frequency (fres).

15. A micromechanical resonator device (1) according to claim 14, wherein the bias is a bias voltage (V), and the bar resonator (2) has a predetermined width ($W_o$), and the excitation element (3) comprises electrodes (3) located at a predetermined gap distance (do) from the bar resonator (2), and whereby the width (Wo) and the gap distance (do) and the bias voltage (V) satisfy the following formula:

$$ET_{bar}^* = 1 + \frac{\alpha}{27}\left(\frac{V}{V_{PI\_0}}\right)^2\left\{3\left[CTE_{sub}^* + \frac{W_0}{2d_0}\left(CTE_{sub}^* - 1\right)\right] - 2\right\}$$

whereby: $ET_{bar}^* = \dfrac{ET_{bar}}{CTE_{bar}}$ and $CTE_{sub}^* = \dfrac{CTE_{sub}}{CTE_{bar}}$

and $V_{pi\_0} = \sqrt{\dfrac{16}{27}\dfrac{E_0 d_0^3}{\varepsilon_0 W_0}}$

and wherein V is the bias voltage to be applied, and $V_{PI\_O}$ is a characterisic pull-in voltage of the resonator device, and Wo is the predetermined width of the bar resonator, and do is the predetermined gap distance, and $CTE_{sub}$ is the coefficient of thermal expansion of the substrate material, and $CTE_{bar}$ is the coefficient of thermal expansion of the material of the bar resonator, and Eo is the Young's modulus of the material of the bar resonator at the predetermined temperature To, and $ET_{bar}$ is the temperature coefficient of the Young's modulus of the material of the bar resonator, and $\alpha$ is a constant.

16. The micromechanical resonator device (1) according to claim 13, wherein the resonator body (2) is a free-standing bar resonator (2) adapted to resonate in a flexural vibration mode above and parallel to the plane of the substrate substantially at the predetermined resonance frequency (fres).

17. The micromechanical resonator device (1) according to any one of claims 13-16, wherein the transconductive structure comprises an interdigitated structure with a first set of fingers connected to the excitation element (3) and a second set of fingers connected to the resonator body (2) and wherein the set of parameters further comprises an overlap between the first and second set of fingers.

18. The micromechanical resonator device (1) according to any one of the claims 13-17, wherein the resonator body (2) comprises a material selected from the group of (poly)silicon, diamond, ruby, sapphire, quartz, alumina, nickel and SiGe.

19. The micromechanical resonator device (1) according to any one of the claims 13-18, wherein the substrate comprises a material selected from the group consisting of silicon, diamond, ruby, sapphire, glass, quartz, alumina and LCP.

**Fig. 1A**

**Fig. 1B**

EP 2 362 199 A1

Bar, 2

Detection Electrode

Anchor

L

d

gap

t

w

**Fig. 1C**

**3, Excitation Electrode**

2

V

$v_{in} \sim$

**Exc Elec**

**Bar**

**Det Elec**

$i_{out} \sim$

3

d

W

d

**Fig. 1D**

Fig. 1F

Excitation
Electrode

Anchor

Detection
Electrode

gap

Bar

Anchor

Fig. 1E

Fig. 2

$$f_{res\,0} = \frac{1}{2W(T)}\sqrt{\frac{E(T)}{\rho(T)}}$$

$f_{res0}$ drift across the full T-range ~ 2966ppm

Fig. 3

$$f_{res\,V} = \frac{1}{2W}\sqrt{\frac{E}{\rho}\left[1 - \frac{\alpha}{27}\left(\frac{V}{V_{pi}}\right)^2\right]}$$

Fig. 4

$$f_{res,T} = \frac{1}{2W(T)}\sqrt{\frac{E(T)}{\rho(T)}}\left[1 - \frac{\alpha}{27}\left(\frac{V}{V_{PI}}\right)^2\right]$$

Fig. 5B

Fig. 5A

Fig. 6

Fig. 7

Electrode,3

resonator body, 2

Anchor

**Fig. 8**

Fig. 9

**Fig. 10**

Anchor

L          L

Electrode, 3          **Fig. 11**          resonator body, 2

**Fig. 12**

Fig. 13

Fig. 16

$f_{res2}$

$f_{res1}$

$f_{res}$

t

Fig. 15

$f_{res2}$

$f_{res1}$

$f_{res}$

t

Fig. 14

$V_{bias2}$

$V_{bias1}$

$V_{bias}$

t

EP 2 362 199 A1

Fig. 17

EP 2 362 199 A1

Fig. 18

Detection coils

Excitation coils

3

Tuning fork resonator

2

μ

gap

Europäisches
Patentamt

European
Patent Office

Office européen
des brevets

# EUROPEAN SEARCH REPORT

Application Number

EP 10 16 6586

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WAN-THAI HSU ET AL: "A resonant temperature sensor based on electrical spring softening", TRANSDUCERS '01. EUROSENSORS XV. 11TH INTERNATIONAL CONFERENCE ON SOLID-STATE SENSORS AND ACTUATORS. DIGEST OF TECHNICAL PAPERS SPRINGER-VERLAG BERLIN, GERMANY, vol. 2, 2001, pages 1484-1487, XP002610040, ISBN: 3-540-42150-5 * abstract; figures 1,2,8,9 * * page 1487 * * paragraph [000V] * | 1,5-8 | INV. G01K7/32 H03H9/02 |
| A,D | KOSKENVUORI M ET AL: "Temperature measurement and compensation based on two vibrating modes of a bulk acoustic mode microresonator", 1 January 2008 (2008-01-01), IEEE 21ST INTERNATIONAL CONFERENCE ON MICRO ELECTRO MECHANICAL SYSTEMS, 2008 : MEMS 2008 ; 13 - 17 JAN. 2008, TUCSON, ARIZONA, USA, PISCATAWAY, NJ : IEEE OPERATIONS CENTER, PAGE(S) 78 - 81, XP031210687, ISBN: 978-1-4244-1792-6 * abstract; figure 2 * | 1-12 | |
| A | US 7 211 926 B2 (QUEVY EMMANUEL P [US] ET AL) 1 May 2007 (2007-05-01) * column 2, lines 1-15 * * column 3, lines 29-54; figure 4 * | 1-12 | TECHNICAL FIELDS SEARCHED (IPC) G01K H03H |
| A,D | US 2007/290764 A1 (PARTRIDGE AARON [US] ET AL) 20 December 2007 (2007-12-20) * abstract * * paragraph [0045] * | 1-12 | |

The present search report has been drawn up for all claims

| Place of search | Date of completion of the search | Examiner |
|---|---|---|
| The Hague | 17 November 2010 | de Bakker, Michiel |

EPO FORM 1503 03.82 (P04C01)

## ANNEX TO THE EUROPEAN SEARCH REPORT
## ON EUROPEAN PATENT APPLICATION NO.

EP 10 16 6586

This annex lists the patent family members relating to the patent documents cited in the above-mentioned European search report.
The members are as contained in the European Patent Office EDP file on
The European Patent Office is in no way liable for these particulars which are merely given for the purpose of information.

17-11-2010

| Patent document cited in search report | | Publication date | Patent family member(s) | | Publication date |
|---|---|---|---|---|---|
| US 7211926 | B2 | 01-05-2007 | US | 2006261703 A1 | 23-11-2006 |
| | | | WO | 2006098857 A2 | 21-09-2006 |
| US 2007290764 | A1 | 20-12-2007 | NONE | | |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7369004 B
- US 6987432 B
- US 7427905 B

### Non-patent literature cited in the description

- **M. KOSKENVUORI et al.** Temperature measurement and compensation based on two vibration modes of a bulk acoustic mode microresonator. *IEEE International Conference on Micro Electro Mechanical Systems - MEMS '08,* 2007, 78-81
- **S. STOFFELS ; S. SEVERI ; R. VANHOOF ; R. MERTENS ; R. PUERS ; A. WITVROUW ; H.A.C. TILMANS.** Light sensitive SiGe MEM resonator for detection and frequency tuning applications. *proc. MEMS 2010,* 24 January 2010, 691-694
- **G. BAHL ; R. MELAMUD ; B. KIM ; S. CHANDORKAR ; J. SALVIA ; M. A. HOPCROFT ; R. G. HENNESSY ; S. YONEOKA ; C. M. JHA ; G. YAMA.** Observations of fixed and mobile charge in composite MEMS resonators. *Proc. IEEE Solid-State Sensors, Actuators and Microsystems Workshop,* 01 June 2008, 102-105
- **H. A. C. TILMANS.** Micromechanical sensors using encapsulated built-in resonant strain gauges. *PhD Dissertation Faculty of Electrical Engineering,* 1993
- **H.J. DE LOS SANTOS et al.** RF MEMS for Ubiquitous Wireless Connectivity: Part 1 - Fabrication. *IEEE Microwave Magazine,* December 2004, 36-49
- **H.A.C. TILMANS.** Equivalent circuit representation of electromechanical transducers: I. Lumped-parameter systems. *J. Micromech. Microeng.,* 1996, vol. 6, 157-176